# EUROPEAN PATENT APPLICATION

(11) **EP 3 905 344 A1**
(43) Date of publication of application: **03.11.2021**
(21) Application number: 18944919.2
(22) Date of filing: 24.12.2018
(51) Int. Cl.: H01L 33/40

(54) **LIGHT-EMITTING DIODE AND MANUFACTURING METHOD THEREOF**

(71) Applicant: Quanzhou Sanan Semiconductor Technology Co., Ltd., Quanzhou, Fujian 362343 (CN)
(72) Inventor: WANG, Jing, Tianjin 300384 (CN); KUO, Huan Shao, Tianjin 300384 (CN); WU, Chun-Yi, Tianjin 300384 (CN)
(74) Representative: Petraz, Gilberto Luigi
(86) International application number: PCT/CN2018/123265
(87) International publication number: WO 2020/132843

(57) **Abstract**

Provided are a light-emitting diode and a manufacturing method thereof, comprising: a luminescent epitaxial layer, comprising a first semiconductor layer (110), a light-emitting layer (120) and a second semiconductor layer (130) from bottom to top in sequence; a transparent dielectric layer (200), at least formed on the second semiconductor layer (130), the transparent dielectric layer (200) has a platform (210) and a series of openings (220); the transparent dielectric layer (200) has an ohmic contact layer (310) in the opening (220), a transition layer (320) is provided between the ohmic contact layer (310) and the second semiconductor layer (130), the thermal mobility of the transition layer (320) is lower than that of the ohmic contact layer (310), the problem of material selection in ohmic contact area is solved, the opening area is effectively controlled, and the light absorption in the ohmic contact area is reduced.

## Description

### TECHNICAL FIELD

The present disclosure relates to a semiconductor element, and in particular to a light-emitting diode and a method of manufacturing a light-emitting diode.

### BACKGROUND

People constantly demand on a higher brightness value of LED chips. In order to increase the brightness value, a conventional method to increase a brightness value is to increase the reflectivity of the mirror. A large portion of light emitted from MQW is directed to an opposite direction to the light-output surface. A part of the portion of light is absorbed, and another part of the portion of light is reflected. Therefore, an effective method to increase the reflectivity of the mirror is to decrease the absorption and increase the reflection.

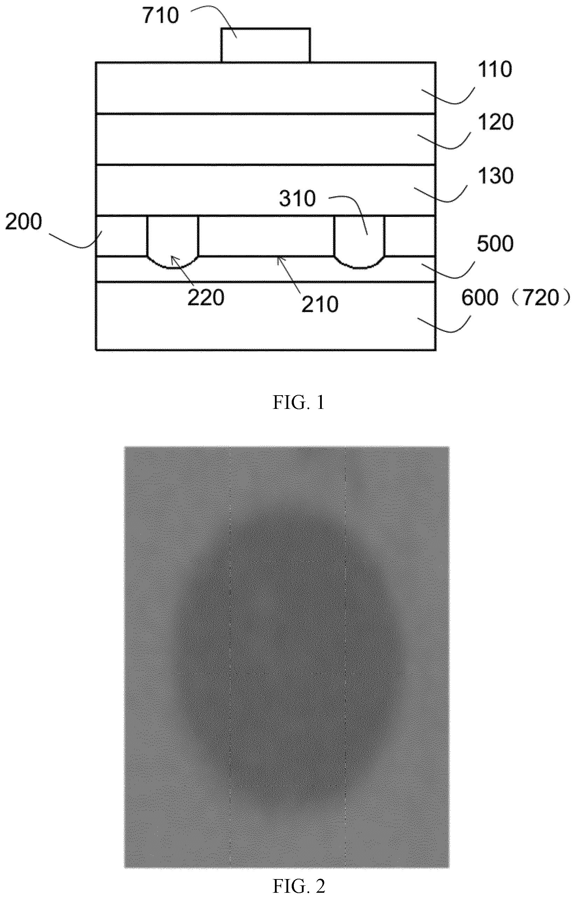

The increase of the reflectivity of the mirror of the mirror system is a conventional method to increase brightness. However, it is also needed to dispose an ohmic contact at one side of the mirror. Referring to FIG. 1, taking a RS product as an example, the conventional implementation of the ohmic contact at the mirror side is the contact of alloy metal, such as AuZn, with GaP. After fusion, AuZn diffuses into GaP to form the ohmic contact. The process in which AuZn diffuses into GaP will result in an uneven interface. Referring to FIG. 2, the ohmic contacts will be observed in the microscope, where the color thereof is darker due to the severe light absorption caused by the unevenness. Another method adopts a transparent conductive layer as an ohmic. A conventional material is ITO. However, since the refractive index of ITO itself is relatively high, and the light transmittance thereof is ordinary, so the reflectivity of mirror will be reduced to a certain extent when adopted as the mirror. Moreover, the ohmic made of ITO and GaP needs to be the same as an AuZn ohmic in voltage, which is required to increase the area of the ITO ohmic. The light absorption of ITO likewise causes a certain loss in brightness.

### SUMMARY OF THE DISCLOSURE

### TECHNICAL PROBLEM

### SOLUTIONS FOR PROBLEM

### TECHNICAL SOLUTIONS

The present disclosure provides a light-emitting diode solving the difficulty problems described in the background, which uses a material having a low thermal mobility as an anti-diffusive blocking thin-film to prevent the ohmic-contact material from diffusing into the window of the luminescent epitaxial layer adopted for the ohmic contact. The unevenness or the light absorption will occur when the ohmic-contact material enters the luminescent epitaxial layer too deeply. Moreover, the opening area is limited not to be excessively large, thereby avoiding the decrease of the reflection area or the light absorption at the opening.

A light-emitting diode includes a luminescent epitaxial layer including a first semiconductor layer, a second semiconductor layer, and a luminescent layer therebetween; and a transparent dielectric layer at least formed at a side of the second semiconductor layer of the luminescent epitaxial layer, the transparent dielectric layer having a platform and a series of openings, the openings exposing the luminescent epitaxial layer. An ohmic-contact layer is disposed in the openings of the transparent dielectric layer, and a transition layer is disposed between the ohmic-contact layer and the luminescent epitaxial layer. A material of the transition layer has a thermal mobility less than that of a material of the ohmic contact layer.

Preferably, the luminescent epitaxial layer exposed by the openings is the first semiconductor layer or the second semiconductor layer according to the present disclosure.

In a first type of embodiments, preferably, the transition layer is a conductive oxide layer.

In this type of embodiments, preferably, the transition layer is ITO, IZO, GZO, or AZO.

In a second type of embodiments, preferably, the transition layer is a metal oxide thin-film or a metal nitride thin-film in the form of thin-film or granula.

In this type of embodiments, preferably, the transition layer is TiN or AIN.

In the first and the second type of embodiments, preferably, the transition layer has a thickness from equal to, or greater than 10 Å to equal to, or less than 200 Å.

In the above-mentioned two types of embodiments, more preferably, the transition layer has a thickness from equal to, or greater than 20 Å to equal to, or less than 50 Å.

Preferably, the transition layer does not impede the electrical conduction between the ohmic-contact layer and the second semiconductor layer according to the present disclosure.

Preferably, the transition layer has a resistivity higher than that of the ohmic-contact layer according to the present disclosure.

Preferably, the material of the ohmic-contact layer is AuBe, AuGe, or AuGeNi.

In a third type of embodiments, preferably, the material of the transition layer is ITO, IZO, GZO, or AZO.

Preferably, the opening has a via diameter from equal to, or greater than, 1.5 µm to equal to, or less than 2.5 µm, or from greater than 2.5 µm to equal to, or less than 10 µm according to the present disclosure.

Preferably, a ratio of the area of the openings to the total area of the transparent dielectric layer is from equal to, or greater than 3% to equal to, or less than 8%, or from greater than 8% to equal to, or less than 15% according to the present disclosure.

Preferably, a material of the transparent dielectric layer is magnesium fluoride or silica according to the present disclosure.

In a fourth type of embodiments, preferably, a reflection layer is disposed at a side of the platform and the ohmic-contact layer away from the luminescent epitaxial layer.

In this type of embodiments, preferably, the reflection layer is Ag, Au, or DBR.

Preferably, the transition layer is disposed between the platform and the reflection layer according to the present disclosure.

For the clear illustration, in some embodiments, the light-emitting diode is defined as outputting light downwardly. It should be noted that the downward direction here is only to facilitate the description of the orientation, but not to limit the practical use.

Preferably, the luminescent epitaxial layer is gallium nitride based or gallium arsenide based according to the present disclosure.

Preferably, the second semiconductor includes gallium phosphide, and the gallium phosphide contacts the transition layer according to the present disclosure.

In order to implement the structure of the above-mentioned light-emitting diode, the present disclosure provides a method of manufacturing the light-emitting diode which includes steps: (1) forming a first semiconductor layer, a luminescent layer, and a second semiconductor layer sequentially on a substrate; (2) forming, on the second semiconductor, a transparent dielectric layer having a platform and a series of openings; (3) forming a sacrificial layer on the platform; (4) covering, with a transparent conductive thin-film, the platform and the openings; (5) covering, with an alloy thin-film, the transparent conductive thin-film; (6) removing the sacrificial layer, and removing the transparent conductive thin-film and the alloy thin-film on the sacrificial layer to expose the platform; (7) forming a metal reflection layer on the platform and the alloy metal thin-film; (8) bonding a support base on the metal reflection layer, the support base being adopted as a second electrode directly, or as a support of a second electrode; and (9) removing the substrate to expose the luminescent epitaxial layer, and forming a first electrode on the exposed luminescent epitaxial layer.

In the manufacturing method, preferably, the metal thin-film has a thickness equal to, or less than 200 Å.

In some embodiments, a simplified method of manufacturing the light-emitting diode can be adopted, including the steps: (1) forming a first semiconductor layer, a luminescent layer, and a second semiconductor layer sequentially on a substrate; (2) forming, on the second semiconductor layer, a transparent dielectric layer having a series of openings; (3) covering, with a transparent conductive thin-film, the platform and the openings; (4) covering, with an alloy thin-film, the transparent conductive thin-film at the openings; (5) forming a metal reflection layer on the platform and the alloy metal thin-film; (6) bonding a support base on the metal reflection layer, the support base being adopted as a second electrode directly, or as a support of the second electrode; and (7) removing the substrate to expose the luminescent epitaxial layer, and forming a first electrode on the exposed luminescent epitaxial layer.

### BENEFICIAL EFFECTS OF THE INVENTION

### BENEFICIAL EFFECTS

The present disclosure includes the following beneficial effects.

By disposing a transition layer in a contact insulating via, the ohmic light absorption can be degraded without changing the area of the ohmic contact while ensuring that the voltage will not be affected significantly, so that an invisible ohmic structure is formed to improve the brightness.

The other characteristics and advantages of the present disclosure will be illustrated in the following description, and be partly apparent from the description, or be understood through implementing the present disclosure. The purpose and other advantages of the present disclose can be achieved and obtained through the structures specifically illustrated in the description, claims and drawings.

Although the present disclose will be described below in connection with some exemplary implementations and methods of use, those skilled in the art should understand that the present disclose is not intended to be limited to these embodiments. On the contrary, it is intended to cover all alternatives, corrections and equivalents included in the spirit and scope of the present disclosure as defined by the appended claims.

### BRIEF DESCRIPTION OF THE DRAWINGS

### DESCRIPTION OF THE DRAWINGS

The accompanying drawings are used to provide a further understanding of the present disclosure, and constitute a part of the specification. Together with the embodiments of the present disclosure, they are used to illustrate the present disclosure and do not constitute a limitation to the present disclosure. In addition, the data of the accompanying drawings is an overall description, not drawn to scale.
FIG. 1 is a schematic diagram illustrating a conventional light-emitting diode;
FIG. 2 is an observed graph of a conventional CB via;
FIGS. 3 and 4 are schematic sectional diagrams of the chip according to the first embodiment of the present disclosure;
FIG. 5 is an observed graph of a CB via according to the first of the present disclosure;
FIG. 6 is a schematic sectional diagram illustrating a chip according to the second embodiment of the present disclosure;
FIG. 7 is a schematic sectional diagram illustrating a chip according to the third embodiment of the present disclosure; and
FIG. 8 is a schematic sectional diagram illustrating a chip according to the forth embodiment of the present disclosure.

It is illustrated in the drawings: 110, first semiconductor layer; 120, luminescent layer; 130, second semiconductor layer; 200, transparent dielectric layer; 210, platform; 220, opening; 310, ohmic-contact layer; 320, transition layer; 400, growth substrate; 500, reflection layer; 510, via; 520, second step; 600, support base; 710, first electrode; 720, second electrode; 800, sacrificial layer.

### EMBODIMENTS OF THE DISCLOSURE

### EMBODIMENTS OF THE PRESENT DISCLOSURE

The implementations of the present disclosure will be described below in detail with reference to the accompanying drawings and embodiments, so as to thoroughly understand how the present disclosure applies technical means to solve technical problems and understand the realization process of technical effects, and thereby implementing them accordingly. It should be noted that, as long as there is no conflict, each embodiment of the present disclosure and each feature in each embodiment can be combined with each other, and the technical solutions formed are all within the protection scope of the present disclosure.

It should be understood that all terms used in the present disclosure are for the purpose of the description of the detained embodiments only, rather intended to limit the present disclosure. As used in the present disclosure, the singular forms "a", "an" and "the" are also intended to include plural forms, unless otherwise clearly stated in the context. It should be further understood that when the terms "comprising", "including" and "containing" are used in the present disclosure, they are used to indicate the presences of the stated features, wholes, steps, actions, elements, and/or packages, but do not exclude the presences or increase of one or more other features, wholes, steps, actions, elements, packages, and/or combinations thereof.

Unless otherwise defined, all terms (including technical terms and scientific terms) used in the present disclosure have the same meanings as commonly understood by those of ordinary skill in the art to which the present disclosure belongs. It should be further understood that the terms used in the present disclosure should be understood as having the meanings consistent with the meanings of these terms in the context of this specification and in related fields, and should not be understood in an idealized or overly formal sense, unless they are so defined in the present disclosure.

The present disclosure generally discloses a chip structure of a light-emitting diode using an insulating via as an ohmic contact. An overall light output of the light-emitting diode is improved by a selection of a filling material of the insulating via. The insulating dielectric has a protection effect (PV layer) or a current-blocking effect (CB layer).

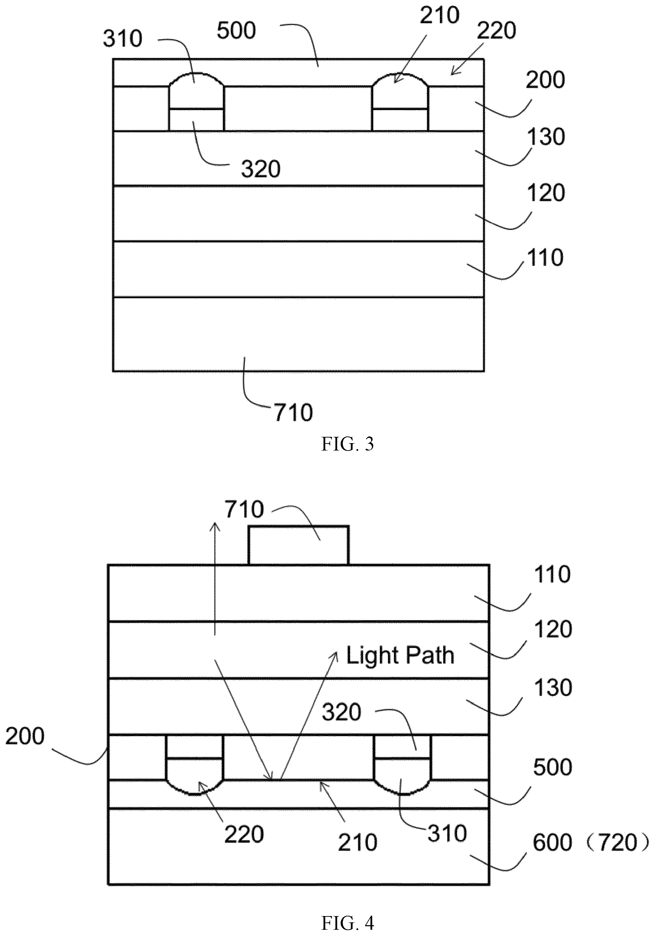

Referring to FIG. 3, a first embodiment of the present disclosure is designed for a gallium-arsenide-based light-emitting diode. The chip structure of the light-emitting diode according to this embodiment has a luminescent epitaxial layer exciting light-emitting, the luminescent epitaxial layer including, from bottom to top, a first semiconductor layer 110, a luminescent layer 120, and a second semiconductor layer 130; a transparent dielectric layer 200 formed, at least, on the second semiconductor layer 130, the transparent dielectric layer 200 having a platform 210 and a series of openings 220, wherein the series of openings 220 refer to the multi-via transparent dielectric layer 200, and the openings 220 expose the luminescent epitaxial layer; an ohmic-contact layer 310 disposed in the openings 220 of the transparent dielectric layer, wherein the ohmic-contact layer 310 is not limited only to a metal layer contacting the luminescent epitaxial layer, but includes a metal layer indirectly contacting the luminescent epitaxial layer. A transition layer 320 is disposed between the ohmic-contact layer 310 and the second semiconductor layer 130. The transition layer 320 has a thermal mobility less than that of the ohmic-contact layer 310. During high temperature annealing, a migration from the transition layer 320 to the second semiconductor layer 130 is not easy, and the transition layer 320 prevents a migration from the material of the ohmic contact layer 310 to the second semiconductor layer 130. In this embodiment, a growth substrate 400 is disposed at an away side of the first semiconductor layer 110. The growth substrate 400 is a temporary substrate rather than a permanent substrate.

In this embodiment, a side of the second semiconductor layer 130 contacting the transition layer 320 is gallium phosphide. The transition layer 320 is a conductive oxide layer, preferably made of ITO formed by evaporation using E-Beam electron beam, or other materials such as ITO, IZO, GZO or AZO formed by other processes, which have higher resistivity than that of the ohmic-contact layer. The ohmic-contact layer 310 is formed on the transition layer 320 in the insulating opening, which is preferably made of AuBe, AuGe or AuGeNi. The dielectric material of the insulating opening 320 is MgF2.

Taking E-Beam ITO as an example, since the conductivity of ITO is lower than that of alloys, in order to ensure and improve the conductivity of the ohmic contact layer 310, enhance the external quantum efficiency, and reduce light loss, so ITO is designed as a thin-film structure or a granular structure. The transition layer 320 has a thickness from equal to, or greater than 10 Å to equal to, or less than 200 Å. In some embodiments, the transition layer 320 can have a thickness from equal to, or greater than 20 Å to equal to, or less than 50 Å. The ultra-thin ITO will not significantly affect the electrical properties, and effectively avoid the unevenness of the ohmic contact layer 310 after the annealing process which otherwise results in severe light absorption that causes a darker color. According to the chip structure of the light-emitting diode of the embodiment, a via diameter of the opening 220 can be controlled from equal to or greater than 1.5 µm to equal to or less than 2.5 µm, or from greater than 2.5 µm to equal to or less than 10 µm. A ratio of the area of the openings 220 to the total area of the transparent dielectric layer is from equal to, or greater than 3% to equal to, or less than 8%, or from greater than 8% to equal to, or less than 15%. That is, the ultra-thin ITO and the ohmic contact area made of alloys can reduce the opening area as much as possible while ensuring current scalability. When the opening area is small, the light absorption is small, and the area of the reflected light-output is increased. The light is generally transmitted to the reflection layer 500 through the transparent dielectric layer 200 and then the light is output upwardly.

The reflection layer 500 is disposed at a side of the platform and the ohmic-contact layer away from the luminescent epitaxial layer. The reflection layer 500 can be a reflective metal, such as Ag, Au, or the like. The reflective layer 500 generally refers to a material with a reflection effect in a broad sense, such as most metals.

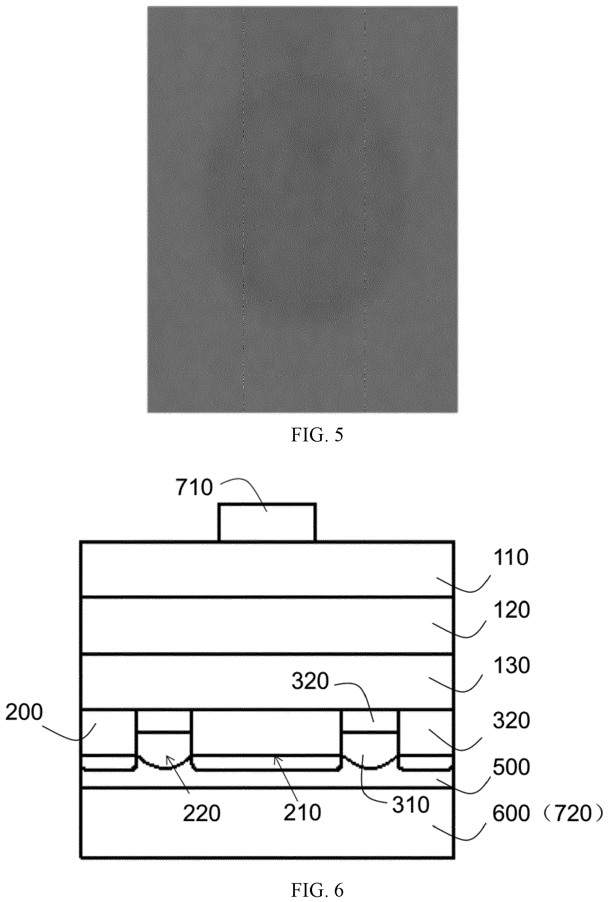

In this embodiment, the above-mentioned chip can be considered as a structure in processing during manufacturing the light-emitting diode. It will be further processed in the embodiment. In order to facilitate the understanding, FIG. 3 is inverted with respect to FIG. 4. That is, referring to FIG. 4, in the structure, the light is output upwardly, and the arrow is the light transmission path. Therefore, a side of the reflection layer 500 away from the luminescent layer 120 can be bonded to a support base 600. The support base 600 can be adopted directly as a second electrode 720, or can also be adopted as a support of the second electrode 720. The growth substrate 400 is to be removed after the bonding to expose the luminescent epitaxial layer. A first electrode 710 is formed on the luminescent epitaxial layer. Referring to FIG. 5, in this embodiment, the color shade of the dark-colored CB via in the middle is obviously reduced, which effectively improves the brightness of the light-output.

The luminescent epitaxial layer exposed by the openings is the first semiconductor layer or the second semiconductor layer. The openings 220 described in the above-mentioned embodiment extend to the second semiconductor layer. However, in some embodiments, the openings 200 pass through the second semiconductor layer 130 and the luminescent layer 120, and extend to the first semiconductor 110, which can have the same effect.

According to the chip structure of the light-emitting diode of the first embodiment of the present disclosure, provided is a corresponding manufacturing method, including steps: (1) forming a first semiconductor layer 110, a luminescent layer 120, and a second semiconductor layer 130 sequentially on a gallium-arsenide growth substrate 400; (2) forming, on the second semiconductor 120, a transparent dielectric layer 200 having a platform 210 and a series of openings 220 by a yellow-light lithography process; (3) forming a sacrificial layer 800 on the platform 210, a material of the sacrificial layer 800 being such as photoresist or other easily removable adhesive material; (4) covering the sacrificial layer 800 and the openings 220 with a transparent conductive thin-film used as a transition layer 320; (5) covering the transparent conductive thin-film with an alloy thin-film used as an ohmic-contact layer 310; (6) removing the sacrificial layer 800, and removing the transparent conductive thin-film and the alloy thin-film on the sacrificial layer 800 to expose the platform 210; and (7) forming a metal reflection layer 500 on the platform 210 and the alloy metal thin-film.

A subsequent structure is further manufactured, including steps: (8) bonding a support base 600 on a surface of the metal reflection layer 500, wherein the support base 600 can be directly used as a second electrode 720, or can be used as a support of the second electrode 720, then removing the gallium-arsenide growth substrate 400 to expose the luminescent epitaxial layer, and forming a first electrode 710 on the exposed luminescent epitaxial layer.

In some modifications of the first embodiment, the alloy thin-film is so designed to have a thickness equal to or less than 200 Å. When the thickness of the evaporated metal is equal to or less than 200 Å, the metal thin-film is transparent. Therefore, an invisible ohmic structure having the transparent conductive ITO layer and the transparent metal layer is formed. When this structure is combined with an Ag mirror manufacturing process of the reflection layer 500, it can increase the reflectivity of the ohmic position more significantly, which further increases the brightness.

In a second embodiment of the present disclosure, referring to FIG. 6, the gallium arsenide based is as same as the first embodiment. The difference, compared to the first embodiment, is that a transition layer 320 is disposed between the platform 210 and the reflection layer 500. Corresponding to the chip structure, provided is a method of manufacturing the structure of the embodiment, including steps: (1) forming a first semiconductor layer 110, a luminescent layer 120, and a second semiconductor layer 130 sequentially on a gallium-arsenide growth substrate 400; (2) forming, on the second semiconductor layer 130, a transparent dielectric layer 200 having a platform 210 and a series of openings 220; (3) covering the platform 210 and the openings 220 with a transparent conductive thin-film; (4) covering the transparent conductive thin-film at the openings 220 with an alloy thin-film; and (5) forming a metal reflection layer 500 on the platform 210 and the alloy metal thin-film.

A subsequent structure is further manufactured, including steps: (6) bonding a support base 600 on a surface of the metal reflection layer 500, wherein the support base 600 can be directly used as a second electrode 720, or can be used as a support of the second electrode 720; and (7) removing the gallium-arsenide growth substrate 400 to expose the luminescent epitaxial layer, and forming a first electrode 710 on the exposed luminescent epitaxial layer.

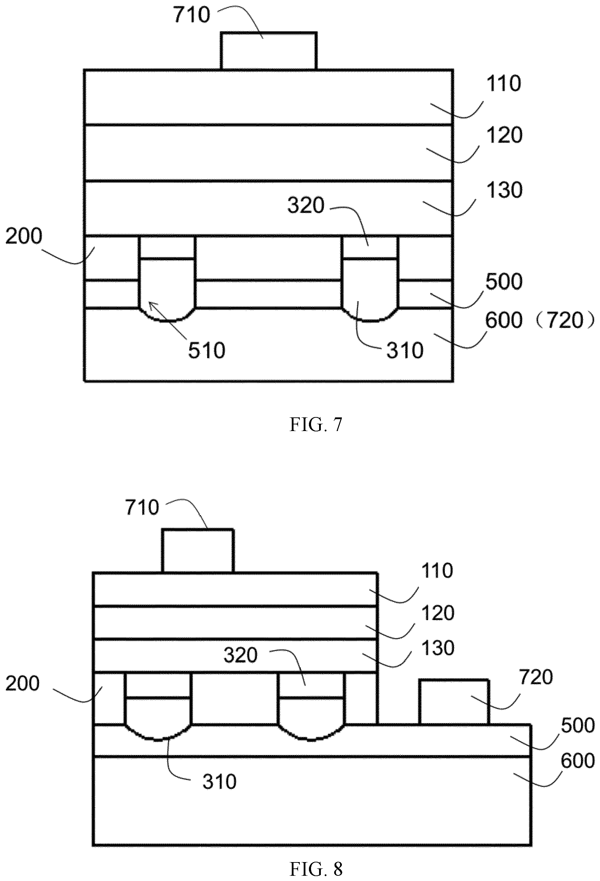

In a third embodiment of the present disclosure, referring to FIG. 7, the difference between this embodiment and Embodiment One is that the reflection layer 500 includes a Distributed-Bragg-Reflection (DBR) layer, or consists of a DBR and a metal reflection layer. The DBR has vias 510 corresponding to the openings 220 of the transparent dielectric layer 200. The vias 510 is filled with a conductive material, for example, a metal conventionally used for electrical contacts.

In a fourth embodiment of the present disclosure, referring to FIG. 8, it can also achieve a good effect when the design of the present disclosure is applied to a gallium nitride based chip, for example, in the chip structure shown in the figure. In this structure, the chip emits light upwardly, and has the luminescent epitaxial layer of Embodiment One, which will not be repeatedly described herein. As shown in the figure, the substantial difference is that the support base 600 can be made of silicon or heat dissipation ceramics; the reflection layer 500 is a metal layer and extends outwardly to form a second step 520, and a second electrode 720 is formed on the second step 520; a transparent dielectric layer 200 is formed between the reflection layer 500 and the luminescent epitaxial layer, and a material used in the transparent dielectric layer 200 can be for example silica or silicon nitride; the transparent dielectric layer 200 has a platform 210 and a series of openings 220 adapted for an electrical conduction; and two types of conductive materials are filled in the openings 220, the conductive material proximate to the luminescent epitaxial layer is a transition layer 320, and the conductive material away from the luminescent epitaxial layer is an ohmic-contact layer 310, wherein the transition layer 320 has a thermal mobility less than that of the ohmic-contact layer 310. The ohmic-contact layer 310 is made of metal or alloys, and the transition layer 320 is made of conductive metal oxides, ultra-thin metal nitrides, or metal having a lower thermal mobility, which have a thermal mobility less than that of the ohmic-contact layer 310. In the thin-film structure, metal oxides or metal nitrides are electrically conductive due to tunneling. The nitrides can be, for example, titanium nitride or aluminum nitride.

It should be noted that the above-mentioned embodiments are only used to illustrate the present disclosure, but not to limit the present disclosure. Those skilled in the art can make various modifications to the present disclosure without departing from the spirit and scope of the present disclosure. Therefore, all equivalent technical solutions also fall within the scope of the present disclosure. The scope of the present disclosure sought to be protected shall be limited by the scope of the claims.

## Claims

1. A light-emitting diode, comprising: a luminescent epitaxial layer comprising a first semiconductor layer, a second semiconductor layer, and a luminescent layer therebetween; a transparent dielectric layer at least formed at a side of the second semiconductor layer of the luminescent epitaxial layer, the transparent dielectric layer having a platform and a series of openings, the openings exposing the luminescent epitaxial layer; an ohmic-contact layer disposed in the openings of the transparent dielectric layer, wherein a transition layer is disposed between the ohmic-contact layer and the luminescent epitaxial layer, and a material of the transition layer has a thermal mobility less than that of a material of the ohmic contact layer.

2. The light-emitting diode of claim 1, wherein the luminescent epitaxial layer exposed by the openings is the first semiconductor layer or the second semiconductor layer.

3. The light-emitting diode of claim 1, wherein the transition layer is a conductive oxide layer.

4. The light-emitting diode of claim 1, wherein the transition layer is ITO, IZO, GZO, or AZO.

5. The light-emitting diode of claim 1, wherein the transition layer is a metal oxide or a metal nitride, and is in a form of a thin-film or a granula.

6. The light-emitting diode of claim 1, wherein the transition layer is TiN or AIN.

7. The light-emitting diode of any one of claims 3 to 6, wherein the transition layer has a thickness from equal to or greater than 10 Å to equal to or less than 200 Å.

8. The light-emitting diode of any one of claims 3 to 6, wherein the transition layer has a thickness from equal to or greater than 20 Å to equal to or less than 50 Å.

9. The light-emitting diode of claim 1, wherein the transition layer does not impede electrical conduction between the ohmic-contact layer and the second semiconductor layer.

10. The light-emitting diode of claim 1, wherein the transition layer has a resistivity greater than that of the ohmic-contact layer.

11. The light-emitting diode of claim 1, wherein a material of the ohmic-contact layer is AuBe, AuGe, or AuGeNi.

12. The light-emitting diode of claim 11, wherein the material of the ohmic-contact layer has a thickness equal to or less than 200Å.

13. The light-emitting diode of claim 1, wherein a material of the ohmic-contact layer is ITO, IZO, GZO, or AZO.

14. The light-emitting diode of claim 1, wherein the openings have a via diameter from equal to or greater than 1.5 µm to equal to or less than 2.5 µm, or from greater than 2.5 µm to equal to or less than 10 µm.

15. The light-emitting diode of claim 1, wherein a ratio of an area of the openings to a total area of the transparent dielectric layer is from equal to or greater than 3% to equal to or less than 8%, or from greater than 8% to equal to or less than 15%.

16. The light-emitting diode of claim 1, wherein a material of the transparent dielectric layer is magnesium fluoride or silica.

17. The light-emitting diode of claim 1, wherein a reflection layer is disposed at a side of the platform and the ohmic-contact layer away from the luminescent epitaxial layer.

18. The light-emitting diode of claim 17, wherein the reflection layer is Ag, Au, or DBR.

19. The light-emitting diode of claim 1, wherein the transition layer is disposed between the platform and a reflection layer.

20. The light-emitting diode of claim 1, wherein, the luminescent epitaxial layer is gallium nitride based or gallium arsenide based.

21. The light-emitting diode of claim 1, wherein the second semiconductor comprises gallium phosphide, and the gallium phosphide contacts the transition layer.

22. A method of manufacturing a light-emitting diode, comprising steps: (1) forming a first semiconductor layer, a luminescent layer, and a second semiconductor layer sequentially on a substrate; (2) forming, on the second semiconductor, a transparent dielectric layer having a platform and a series of openings; (3) forming a sacrificial layer on the platform; (4) covering, with a transparent conductive thin-film, the platform and the openings; (5) covering, with an alloy thin-film, the transparent conductive thin-film; (6) removing the sacrificial layer, and removing the transparent conductive thin-film and the alloy thin-film on the sacrificial layer to expose the platform; (7) forming a metal reflection layer on the platform and the alloy metal thin-film; (8) bonding a support base on the metal reflection layer, the support base being adopted as a second electrode directly, or as a support of a second electrode; and (9) removing the substrate to expose the luminescent epitaxial layer, and forming a first electrode on the exposed luminescent epitaxial layer.

23. The method of manufacturing the light-emitting diode of claim 22, wherein the alloy thin-film has a thickness equal to or less than 200 Å.

24. A method of manufacturing a light-emitting diode, comprising steps: (1) forming a first semiconductor layer, a luminescent layer, and a second semiconductor layer sequentially on a substrate; (2) forming, on the second semiconductor layer, a transparent dielectric layer having a platform and a series of openings; (3) covering, with a transparent conductive thin-film, the platform and the openings; (4) covering, with an alloy thin-film, the transparent conductive thin-film at the openings; (5) forming a metal reflection layer on the platform and the alloy metal thin-film; (6) bonding a support base on the metal reflection layer, the support base being adopted as a second electrode directly, or as a support of the second electrode; and (7) removing the substrate to expose the luminescent epitaxial layer, and forming a first electrode on the exposed luminescent epitaxial layer.
